# EUROPÄISCHE PATENTSCHRIFT

(11) **EP 2 145 375 B1**
(45) Veröffentlichungstag und Bekanntmachung des Hinweises auf die Patenterteilung: **03.07.2019**
(21) Anmeldenummer: 08734948.6
(22) Anmeldetag: 01.04.2008
(51) Int. Cl.: H02K 11/215, H02K 11/225, H05K 7/14, H02K 11/21, H02K 9/06

(54) **ELEKTROMOTOR MIT HALTEVORRICHTUNG FÜR EINE LEITERPLATTE**
ELECTRIC MOTOR AND FIXING DEVICE FOR A PRINTED CIRCUIT BOARD
MOTEUR ÉLECTRIQUE ET DISPOSITIF DE MAINTIEN POUR UNE CARTE DE CIRCUITS IMPRIMÉS

(30) Priorität: 10.04.2007 DE 102007017084
(43) Veröffentlichungstag der Anmeldung: 20.01.2010
(73) Patentinhaber: SEW-EURODRIVE GmbH & Co. KG, 76646 Bruchsal (DE)
(72) Erfinder: PFANN, Jochen, 76189 Karlsruhe (DE); WINNWA, Manuel, 66978 Clausen (DE)
(86) Internationale Anmeldenummer: PCT/EP2008/002599
(87) Internationale Veröffentlichungsnummer: WO 2008/122387

(56) Entgegenhaltungen:
- DE-A1- 19 916 521
- JP-A- 6 342 988
- US-A- 5 770 902
- US-A- 5 804 895

## Beschreibung

Die Erfindung betrifft einen Elektromotor **mit einer** Haltevorrichtung für eine Leiterplatte.

Aus der DE 103 40 325 A1 ist ein Elektromotor bekannt, bei dem Sensoren mit einem am Lüfter vorgesehenen Ring abwechselnder Magnetisierung zusammenwirken zur Drehzahlbestimmung.

**Aus der** US 5 770 902 **ist** ein Elektromotor gemäß dem Oberbegriff des Anspruchs 1 **bekannt.**

Der Erfindung liegt daher die Aufgabe zugrunde, möglichst kompakte Elektromotoren weiterzubilden.

Erfindungsgemäß wird die Aufgabe bei dem Elektromotor nach den in Anspruch 1 angegebenen Merkmalen gelöst.

Wichtige Merkmale der Erfindung bei der Haltevorrichtung sind, dass sie für eine Haltevorrichtung für eine Leiterplatte vorgesehen ist, wobei laschenförmige Bereiche eines Bleches in Ausnehmungen einer Leiterplatte vorgesehen sind.

Von Vorteil ist dabei, dass eine Leiterplatte in einfacher Weise befestigbar ist, wobei die Laschen eine formschlüssige Verbindung herstellbar machen. Außerdem ist das Halteblech auf einer der beiden Seiten der Leiterplatte angeordnet und somit eine Abschirmwirkung gegen elektromagnetische Felder erzielbar durch das Halteblech selbst. Allerdings ist zwischen den Leiterbahnen der Leiterplatte und dem Blech ein genügend großer Isolationsabstand vorgesehen.

Bei einer vorteilhaften Ausgestaltung ist das Halteblech als Stanz-Biegeteil vorgesehen und die laschenförmigen Bereiche in Richtung auf die Leiterplatte zu aus dem Blech herausgebogen.

Von Vorteil ist dabei, dass ein kostengünstiges Teil herstellbar ist und die Haltevorrichtung sehr kompakt ausführbar ist.

Bei einer vorteilhaften Ausgestaltung ist mindestens eine der Ausnehmungen rund ausgeführt. Von Vorteil ist dabei, dass die Laschen in ihren Endbereichen Quaderförmig ausführbar sind und einsteckbar sind in die Ausnehmungen der Leiterplatte. Beim Einstecken werden dann die mechanische und elektrische Verbindung herstellbar.

Bei einer vorteilhaften Ausgestaltung ist das Halteblech einerseits elektrisch, insbesondere zur Erdung und/oder Masseverbindung, mit zumindest einer Durchkontaktierung und/oder einer Leiterbahn der Leiterplatte verbunden und andererseits mit dem Motorflansch. Von Vorteil ist dabei, dass Durchkontaktierungen und Leiterbahnen der Leiterplatte ohne besonderen Zusatzaufwand zur Verfügung stellbar sind.

Bei einer vorteilhaften Ausgestaltung ist die Leiterplatte mit Vergussmasse derart vergossen, dass die Vergussmasse die Leiterplatte samt der darauf bestückten Bauelemente sowie die laschenförmigen Bereiche des Halteblechs umbgibt. Von Vorteil ist dabei, dass die relative Lage des Bleches zur Leiterplatte stabilisierbar ist und Schwingungen abdämpfbar sind. Außerdem ist die Isolation verbessert, da die Vergussmasse einen verringerten Isolationsabstand bewirkt.

Bei einer vorteilhaften Ausgestaltung trägt die Vergussmasse zur Verbindung zwischen Blech und Leiterplatte bei. Von Vorteil ist dabei, dass die Verbindung verbessert ist und die Wärme der auf der Leiterplatte bestückten Bauelemente aufspreizbar ist. Außerdem ist die Wärme nicht nur von der Vergussmasse an die Umgebung sondern auch von der Vergussmasse an über die Haltevorrichtung an den Motorflansch abtransportierbar, insbesondere wenn das Blech direkt auf diesen montiert ist, also keine Haltebolzen verwendet sind.

Erfindungsgemäß ist die Lasche derart in eine durchkontaktierte Ausnehmung der Leiterplatte eingeschoben, dass die metallische Schicht der Durchkontaktierung verformt ist und somit eine mechanische Verbindung zum Halten der Leiterplatte und eine elektrische Verbindung zur Bildung einer Masseverbindung erreicht ist. Von Vorteil ist dabei, dass die mechanische und elektrische Verbindung in einem einzigen Arbeitsgang herstellbar ist.

Bei einer vorteilhaften Ausgestaltung umfasst die Haltevorrichtung Haltebolzen, an denen das Halteblech verbunden und gehalten ist. Von Vorteil ist dabei, dass die Bremse überbrückbar ist und somit die Leiterplatte auf der vom Motor abgewandten Seite einer Bremse haltbar ist. Insbesondere axial weiter beabstandet von der Bremse ist ein Lüfter, der die Geberfahnen für die auf der Leiterplatte bestückten Sensoren umfasst.

Wichtige Merkmale bei dem Elektromotor sind, dass er einen Motorflansch als ein Gehäuseteil umfasst, wobei am Motorflansch ein Halteblech zum Halten einer Leiterplatte vorgesehen ist. Die Haltevorrichtung ist in vorbeschriebener Weise ausgeführt. Von Vorteil ist dabei, dass eine Leiterplatte im Bereich des Motors befestigt ist.

Bei einer vorteilhaften Ausgestaltung umfasst der Elektromotor eine Bremse und/oder einen Lüfter. Von Vorteil ist dabei, dass die Leiterplatte zwischen Bremse und Lüfter oder alternativ am Motorgehäuseteil selbst befestigbar ist.

Bei einem Beispiel, welches nicht Teil der Erfindung ist, ist die axiale Länge der Haltebolzen länger als die axiale Länge der Bremse. Von Vorteil ist dabei, dass die Befestigung der Leiterplatte nicht an der Bremse und deren Gehäuseteile erfolgen muss, sondern am stabilen Motorflansch ausführbar ist.

Bei einem Beispiel, welches nicht Teil der Erfindung ist, ist das Halteblech zwischen Bremse und/oder Stator einerseits und Leiterplatte andererseits angeordnet. Von Vorteil ist dabei, dass eine abschirmende Wirkung erzielbar ist für aus der Bremse oder aus dem Stator austretende elektromagnetische Felder, also auch magnetische Felder.

Bei einer vorteilhaften Ausgestaltung ist das Halteblech als Masseverbindung zwischen dem Gehäuseteil des Motors und der Leiterplatte vorgesehen. Von Vorteil ist dabei, dass die Befestigungsvorrichtung zur Erdung oder Masseverbindung verwendbar ist.

Bei einem Beispiel, welches nicht Teil der Erfindung ist, ist die Leiterplatte mit Sensoren bestückt, die in Wirkverbindung treten mit magnetisierten Bereichen an einem Lüfter des Motors, insbesondere an dessen Lüfterflügeln, an dessen Leitring oder am Umfang des Lüfters. Von Vorteil ist dabei, dass die Leiterplatte nahe am Lüfter haltbar ist, insbesondere an seiner einen axialen Seite und der Lüfter gleichzeitig die Lüfterfunktion zur Kühlung des Motors und andererseits die Funktion der Geberfahnen für die Sensoren umfasst.

Bei einem Beispiel, welches nicht Teil der Erfindung ist, umfasst die Leiterplatte einen Umdrehungszähler und/oder Winkellagensensor zur Erfassung der Winkellage des Rotors. Von Vorteil ist dabei, dass am nicht besonders stabilen Lüfter trotzdem diese Daten erfassbar sind. Es sind also keine weiteren und speziellen Teile notwendig.

Bei einem Beispiel, welches nicht Teil der Erfindung ist, ist die Elektronik der Leiterplatte zumindest teilweise aus den Sensoren selbst versorgbar, insbesondere Impulsdrahtsensoren. Von Vorteil ist dabei, dass die Energie der übermittelten Pulse verwendbar ist zur Versorgung der Elektronik und andererseits die Impulse selbst als Sensorsignale verwendet werden. Dabei ist die Fehlerrate verringert mittels des Bleches der Haltevorrichtung und seiner Abschirmwirkung.

### Bezugszeichenliste

1 Stator
2 Motorflansch
3 Haltebolzen
4 Halteblech
5 Lüfterflügel
6 elektromagnetisch betätigbare Bremse
7 Lüfterhaube
30 Leiterplatte
31 elektronisches Bauelement
41 Laschenbereich
42 Ösenbereich

Die Erfindung wird nun anhand von Abbildungen näher erläutert:
In der Figur 1 ist ein axialer Endbereich eines erfindungsgemäßen Elektromotors mit Bremse gezeigt.
In der Figur 2 ist ein axialer Endbereich eines alternativen erfindungsgemäßen Elektromotors ohne Bremse gezeigt.

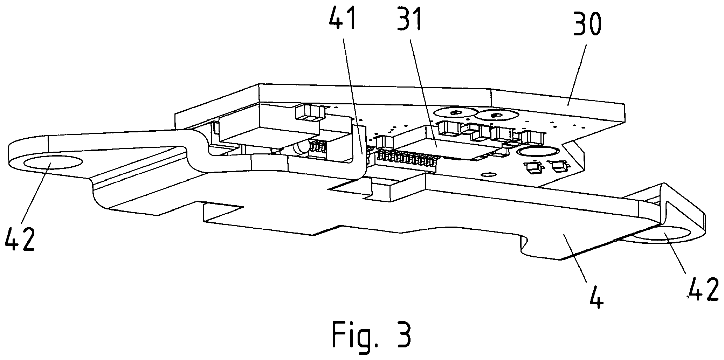

In der Figur 3 ist die Verbindung der Leiterplatte mit dem Halteblech vergrößert dargestellt, wobei Vergussmasse nicht gezeigt ist. Dabei ist die Figur 3 sowohl auf das Ausführungsbeispiel nach Figur 1 als auch auf das Ausführungsbeispiel nach Figur 2 bezogen.

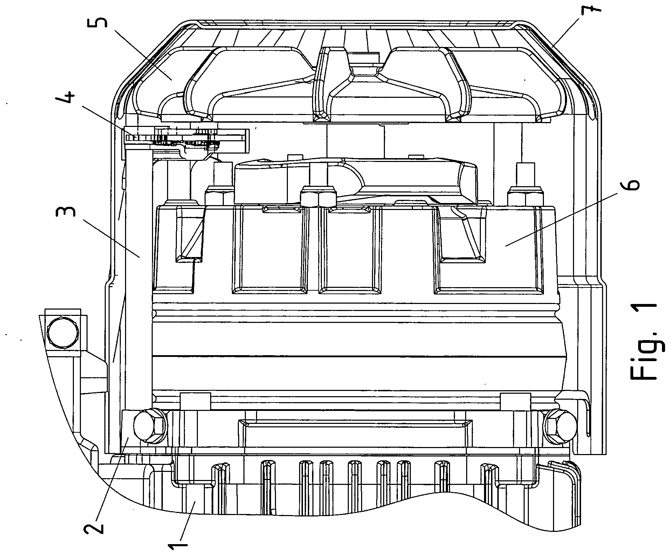

In Figur 1 ist der Stator 1 des Elektromotors gezeigt, wobei an dessen axialem Endbereich ein Motorflansch 2 angeordnet ist, an welchem Haltebolzen 3 formschlüssig verbindbar sind, insbesondere mittels Schraubverbindung.

Am axial anderen Ende der Haltebolzen 3 ist ein Halteblech 4 angeschraubt, das zum Halten einer Leiterplatte 30 vorgesehen ist, die mit elektronischen Bauelementen 31 bestückt ist. Halteblech und leiterplatte samt Bauelementen sind mittels gummiartiger Vergussmasse vergossen.

Die Haltebolzen 3 weisen eine axiale Länge auf, die größer ist als die axiale Länge der elektromagnetisch betätigbaren Bremse 6.

Somit ist der Bereich der Bremse überbrückbar und das Halteblech samt Leiterplatte und Vergussmasse formschlüssig über die Haltebolzen 3 direkt mit dem Motorflansch 2 verbindbar. Daher ist eine bei Schwingungen stabile Befestigung erreicht.

Die Bremse ist mit ihrem Rotor am Rotor des Motors verbindbar oder einstückig ausführbar. Die nicht drehenden Teile der Bremse sind am Motorflansch verbindbar, insbesondere auch als Drehmomentabstützung.

Am axial vom Stator abgewandten Ende des Motors ist ein Lüfter, umfassend mit dem Rotor des Motors verbundene Lüfterflügel 5 und einer mit dem Motorflansch verbundenen Lüfterhaube 7.

Am Lüfter, insbesondere an oder in den Lüfterflügeln, sind in Umfangsrichtung abwechselnd magnetisierte Bereiche vorgesehen. Diese sind in einer ersten Ausführungsbeispiel als auf die Lüfterflügel aufgeklebte Dauermagnete, in einem zweiten als in den Lüfterflügeln umspritzte Dauermagnete vorgesehen und in einem dritten als magnetisierte Bereiche der Lüfterflügel, die aus einem Kunststoff, umfassend magnetisierbare Partikel, bestehen. In einem vierten Beispiel ist ein entsprechend ebenfalls in Umfangsrichtung abwechselnd magnetisierbares Magnetband am äußeren Umfang oder am Leitring aufgeklebt.

Zur Detektion der Winkellage und/oder der Umdrehungen sind auf der Leiterplatte Sensoren, insbesondere umfassend Hallsensoren und/oder Wiegandsensoren, bestückt. Mit diesen lässt sich nicht nur die Drehbewegung sondern auch die Winkellage erkennen. Bei Verwendung von Wieganddrähten als Sensoren, insbesondere auch Impulsdrahtsensoren genannt, und unter Verwendung von FRAM-Speichertechnik ist die elektronische Schaltung sogar derart realisierbar, dass die elektronische Schaltung samt Langzeitspeicher betreibbar ist aus der von den Sensoren erzeugbaren Impulsenergie.

Das Halteblech verbessert einerseits die Abschirmung gegen aus der Bremse in Richtung der Sensoren austretender elektromagnetischer Strahlung, andererseits bietet es eine stabile Befestigung für die Leiterplatte. Des Weiteren ist auch eine elektrische Erde-Verbindung vorsehbar. Hierzu ist das Halteblech 4 einerseits über die Haltebolzen 3 in elektrischer Verbindung mit dem Motorflansch 2, andererseits in elektrischer Verbindung mit. Leiterbahnen und/oder durchkontaktierten Löchern der Leiterplatte.

Das Halteblech 4 ist vorzugsweise ein Stanz-Biegeteil und weist Laschenbereiche 41 auf, so dass die Laschenbereiche 41 herausgebogen sind und in Ausnehmungen der Leiterplatte 30 einsteckbar sind. Dabei ist der Endbereich der Lasche beispielsweise quaderförmig oder quaderähnlich und wird in eine runde, beispielsweise kreisförmige Ausnehmung der Leiterplatte gesteckt. Diese ist durchkontaktiert und die Durchkontaktierung mit Leiterbahnen verbunden. Beim Einstecken der Laschen schneidet sich die Kante in den metallischen Bereich der Durchkontaktierung ein und es ist somit eine elektrische Verbindung hergestellt.

Das Halteblech 4 ist an seinem Ösenbereich 42 mit den Haltebolzen 3 verbunden, wobei die Gewindebereiche durch die Ösenbereiche geführt sind.

Es werden vorzugsweise drei oder mehr Laschen verwendet. Auf diese Weise ist eine Mehrpunktlagerung ausgeführt und somit eine stabile Anordnung erreicht.

Durch das Vergießen mit Vergussmasse sind auch die Laschen umgossen und somit gegebenenfalls eingekoppelte Schwingungen zwischen Leiterplatte und Halteblech verhindert oder zumindest vermindert. Die Vergussmasse trägt auch zur Erhöhung des Isolationsabstandes bei.

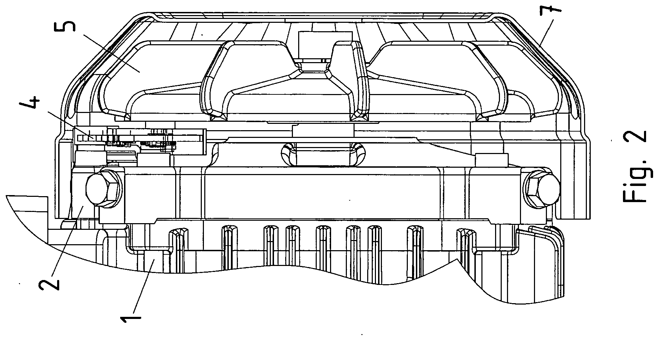

In Figur 2 ist ein Ausführungsbeispiel ohne Bremse gezeigt. Hierbei ist das Halteblech 4 direkt mittels Schrauben mit dem Motorflansch 2 verbunden. Die vom Halteblech 4 bewirkte Abschirmung gegen aus dem Stator austretende elektromagnetische Störfelder ist hierbei besonders wichtig. Denn die Leiterplatte hat einen geringeren Abstand zu den Statorwicklungen des Motors und ist somit noch größeren Feldstärken ausgesetzt.

## Patentansprüche

1. Elektromotor, aufweisend einen Motorflansch (2) als ein Gehäuseteil, mit einem Halteblech (4) für eine Leiterplatte (30),
wobei das Halteblech (4) auf einer der beiden Seiten der Leiterplatte (30) angeordnet ist, so dass eine Abschirmwirkung gegen elektromagnetische Felder durch das Halteblech (4) selbst erzielbar ist,
wobei zwischen den Leiterbahnen der Leiterplatte (30) und dem Halteblech (4) ein Isolationsabstand vorgesehen ist,
wobei am Motorflansch das Halteblech (4) zum Halten der Leiterplatte (30) vorgesehen ist,
wobei laschenförmige Bereiche (41) des Halteblechs (4) als Laschen in Ausnehmungen der Leiterplatte (30) formschlüssig verbunden sind,
**dadurch gekennzeichnet, dass**
jede Lasche derart in jeweils eine durchkontaktierte Ausnehmung der Leiterplatte (30) eingeschoben ist, dass jeweils die metallische Schicht der Durchkontaktierung verformt ist und somit jeweils eine mechanische Verbindung zum Halten der Leiterplatte (30) und jeweils eine elektrische Verbindung zur Bildung einer Masseverbindung erreicht ist.

2. Elektromotor nach Anspruch 1,
**dadurch gekennzeichnet, dass**
das Halteblech (4) als Stanz-Biegeteil vorgesehen ist und die Laschen in Richtung auf die Leiterplatte (30) zu aus dem Halteblech (4) herausgebogen sind.

3. Elektromotor nach mindestens einem der vorangegangenen Ansprüche,
**dadurch gekennzeichnet, dass**
mindestens eine der Ausnehmungen rund ausgeführt ist.

4. Elektromotor nach mindestens einem der vorangegangenen Ansprüche,
**dadurch gekennzeichnet, dass**
das Halteblech (4) einerseits elektrisch, insbesondere zur Erdung und/oder Masseverbindung, mit zumindest einer Durchkontaktierung und/oder einer Leiterbahn der Leiterplatte (30) und andererseits mit dem Motorflansch (2) verbunden ist.

5. Elektromotor nach mindestens einem der vorangegangenen Ansprüche,
**dadurch gekennzeichnet, dass**
die Leiterplatte (30) mit Vergussmasse derart vergossen ist, dass die Vergussmasse die Leiterplatte (30) samt der darauf bestückten Bauelemente sowie die laschenförmigen Bereiche (41) des Halteblechs (4) umgibt, insbesondere die Vergussmasse zur Verbindung zwischen Halteblech (4) und Leiterplatte (30) beiträgt:

6. Elektromotor nach mindestens einem der vorangegangenen Ansprüche,
**dadurch gekennzeichnet, dass**
das Halteblech (4) an Haltebolzen (3) verbunden und gehalten ist.

7. Elektromotor nach mindestens einem der vorangegangenen Ansprüche,
**dadurch gekennzeichnet, dass**
der Elektromotor eine Bremse (6) und/oder einen Lüfter aufweist.

8. Elektromotor nach mindestens einem der vorangegangenen Ansprüche,
**dadurch gekennzeichnet, dass**
das Halteblech (4) als Masseverbindung zwischen dem Motorflansch (2) und der Leiterplatte (30) vorgesehen ist.

## Claims

1. An electric motor having a motor flange (2) as a housing part, with a holding plate (4) for a printed circuit board (30),
wherein the holding plate (4) is arranged on one of the two sides of the printed circuit board (30) so that a shielding effect against electromagnetic fields can be achieved by the holding plate (4) itself,
wherein an insulation spacing is provided between the traces of the printed circuit board (30) and the holding plate (4),
wherein the holding plate (4) for holding the printed circuit board (30) is provided on the motor flange,
wherein bracket-shaped regions (41) of the holding plate (4) are connected with form fit in recesses of the printed circuit board (30) as brackets,
**characterised in that**
each bracket is pushed into a respective plated-through recess of the printed circuit board (30) in such a way that the metal coating of the through-plating is deformed in each case and therefore a respective mechanical connection for holding the printed circuit board (30) and a respective electrical connection for forming an earth connection is achieved.

2. An electric motor according to Claim 1,
**characterised in that**
the holding plate is provided as a punched and bent part and the brackets are bent out of the holding plate (4) in the direction towards the printed circuit board (30).

3. The electric motor according to at least one of the preceding claims,
**characterised in that**
at least one of the recesses is designed to be round.

4. The electric motor according to at least one of the preceding claims,
**characterised in that**
the holding plate (4) is connected, on the one hand, electrically to at least one through-plating and/or a trace of the printed circuit board (30), in particular for grounding and/or earth connection, and, on the other, to the motor flange (2).

5. The electric motor according to at least one of the preceding claims,
**characterised in that**
the printed circuit board (30) is cast with a casting compound in such a way that the casting compound surrounds the printed circuit board (30) including the components assembled thereon and the bracket-shaped regions (41) of the holding plate (4),
in particular, the casting compound contributes to the connection between the holding plate (4) and the printed circuit board (30).

6. The electric motor according to at least one of the preceding claims,
**characterised in that**
the holding plate (4) is connected and held on holding bolts.

7. The electric motor according to at least one of the preceding claims,
**characterised in that**
the electric motor has a brake (6) and/or a fan.

8. The electric motor according to at least one of the preceding claims,
**characterised in that**
the holding plate (4) is provided as an earth connection between the motor flange (2) and the printed circuit board (30) .

## Revendications

1. Moteur électrique, présentant une bride de moteur (2) sous la forme d'un élément de boîtier, avec une tôle de maintien (4) pour une carte à circuits imprimés (30),
sachant que la tôle de maintien (4) est disposée sur un des deux côtés de la carte à circuits imprimés (30), de sorte qu'on peut obtenir un effet de blindage contre les champs électromagnétiques par la tôle de maintien (4) elle-même,
sachant qu'une distance d'isolation est prévue entre les pistes conductrices de la carte à circuits imprimés (30) et la tôle de maintien (4),
sachant que la tôle de maintien (4) destinée à maintenir la carte à circuits imprimés (30) est prévue sur la bride de moteur,
sachant que des régions d'attache (41) de la tôle de maintien (4) sont reliées par complémentarité de forme, sous forme de pattes, dans des évidements de la carte à circuits imprimés (30),
**caractérisé en ce que** chaque patte est insérée dans un évidement métallisé respectif de la carte à circuits imprimés (30) de telle sorte que la couche métallique du trou métallisé est respectivement déformée et donc qu'on obtient respectivement une liaison mécanique pour maintenir la carte à circuits imprimés (30) et respectivement une liaison électrique pour former une prise de masse.

2. Moteur électrique selon la revendication 1, **caractérisé en ce que** la tôle de maintien (4) est prévue sous forme de pièce découpée et pliée, et les pattes sont pliées à partir et hors de la tôle de maintien (4) en direction de la carte à circuits imprimés (30).

3. Moteur électrique selon au moins une des revendications précédentes, **caractérisé en ce qu'**au moins un des évidements est réalisé rond.

4. Moteur électrique selon au moins une des revendications précédentes, **caractérisé en ce que** la tôle de maintien (4) est reliée d'une part électriquement, en particulier pour la mise à la terre et/ou la prise de masse, à au moins un trou métallisé et/ou une piste conductrice de la carte à circuits imprimés (30), et d'autre part à la bride de moteur (2).

5. Moteur électrique selon au moins une des revendications précédentes, **caractérisé en ce que** la carte à circuits imprimés (30) est scellée avec une masse de scellement de telle sorte que la masse de scellement entoure la carte à circuits imprimés (30) conjointement avec les composants dont elle est équipée, ainsi que les régions d'attache (41) de la tôle de maintien (4),
en particulier de telle sorte que la masse de scellement contribue à la liaison entre la tôle de maintien (4) et la carte à circuits imprimés (30).

6. Moteur électrique selon au moins une des revendications précédentes, **caractérisé en ce que** la tôle de maintien (4) est reliée et maintenue à des boulons de maintien (3).

7. Moteur électrique selon au moins une des revendications précédentes, **caractérisé en ce que** le moteur électrique présente un frein (6) et/ou un ventilateur.

8. Moteur électrique selon au moins une des revendications précédentes, **caractérisé en ce que** la tôle de maintien (4) est prévue comme prise de masse entre la bride de moteur (2) et la carte à circuits imprimés (30).
